# EUROPEAN PATENT APPLICATION

(11) **EP 1 865 091 A2**
(43) Date of publication of application: **12.12.2007**
(21) Application number: 07109886.7
(22) Date of filing: 08.06.2007
(51) Int. Cl.: C23C 16/448, C30B 25/14

(54) **High flow GaCI3 delivery**

(30) Priority: 09.06.2006 US 812560 P; 31.05.2007 US 756091
(71) Applicant: Air Products and Chemicals, Inc., Allentown, PA 18195-1501 (US)
(72) Inventor: Steidl, Thomas Andrew, Escondido, CA 92025 (US); Birtcher, Charles Michael, Valley Center, CA 92082 (US); Clark, Robert Daniel, Schenectady, NY 12306 (US); Senecal, Lee Arthur, Vista, CA 92084 (US)
(74) Representative: Muir, Benjamin M. J.

(57) **Abstract**

Vapor phase gallium trichloride is fed to a gallium nitride reactor (52) by injecting a heated (40) carrier gas (10) at an elevated pressure and at least 80°Cinto a container (26) having a supply of melted (40) gallium trichloride (28) to entrain the gallium trichloride, and delivering the carrier gas and entrained gallium trichloride to the reactor through a delivery line (44) at a temperature of at least 80°C. An apparatus for conducting the process is also described.

## Description

### BACKGROUND OF THE INVENTION

The electronics fabrication industry has a keen interest in compound semiconductors, such as gallium-containing films. Historically, gallium-containing compounds have been synthesized by using trimethyl gallium. That synthesis is expensive and slow.

One of the drawbacks in synthesizing gallium-containing compounds is the delivery system for gallium sources, such as room temperature solid gallium trichloride (GaCl₃). Conventional vapor delivery systems for solid precursors are not offered for high flow and high purity delivery of GaCl₃, because of the low vapor pressure of GaCl₃ in its solid state.

Existing liquid vapor delivery systems that can deliver such high flow rates can not accommodate melted (above 80°C) GaCl₃, because of their low temperature capabilities, and the highly corrosive nature of the chlorine chemistry, which is accelerated at higher temperatures.

Existing solid chemical vapor delivery systems exist for lower flow rates only due to the low vapor pressures of most solid precursors. Air Products and Chemicals, Inc., Allentown, PA, USA, has developed a Schumacher brand product solid source vaporizer offering illustrated in US Published Patent Application No. 2005-0039794A1 (corresponding to EP1508631).

Another related liquid vapor delivery system is the Gasguard BSGS Trichlorosilane bubbler module (circa March 1999) offered by Air Products and Chemicals, Inc., Allentown, PA, USA.

The deficiencies of the prior art containers and delivery systems are overcome by the present invention's gallium trichloride container and delivery system which allows for economical and high purity synthesis of gallium-containing compounds for electronics applications.

### BRIEF SUMMARY OF THE INVENTION

The present invention is an apparatus for delivering high purity gallium trichloride in the vapor phase to a reactor for producing gallium-containing compounds, comprising; a source of an inert carrier gas at a pressure elevated above atmospheric pressure; a purifier capable of removing moisture from the carrier gas down to no more than 10 parts per billion ("ppb"), preferably 5 ppb; a heater capable of heating the carrier gas to a temperature of at least 80°C, preferably 110°C; a container having a corrosive resistant inner surface having a supply of gallium trichloride, a valve controlled inlet for the carrier gas that forms a dip tube with an outlet below the level of the gallium trichloride, a valve controlled outlet for removing the carrier gas and gallium trichloride entrained in the carrier gas; a heater capable of heating the container sufficient to melt the gallium trichloride; and a delivery line connected to the valve controlled outlet for carrying the carrier gas and entrained gallium trichloride to a reaction zone for converting the gallium trichloride to gallium-containing compounds.

The present invention is also a process for delivering vapor phase gallium trichloride to a reaction zone for synthesizing gallium-containing compounds, comprising; providing a carrier gas selected from: hydrogen, nitrogen, helium, argon and mixtures thereof at a pressure above atmospheric pressure; purifying the carrier gas by passing the carrier gas through a purifying media selective for the removal of moisture to no more than 10 ppb, preferably 5 ppb; heating the carrier gas to a temperature of at least 80°C, preferably 110°C; injecting the carrier gas into a bath of melted gallium trichloride in a container to entrain the gallium trichloride in the carrier gas; removing the carrier gas and entrained gallium trichloride from the container and delivering the carrier gas and entrained gallium trichloride at a temperature of at least 80°C, preferably 110°C to a reaction zone for synthesizing gallium-containing films.

### BRIEF DESCRIPTION OF THE DRAWING

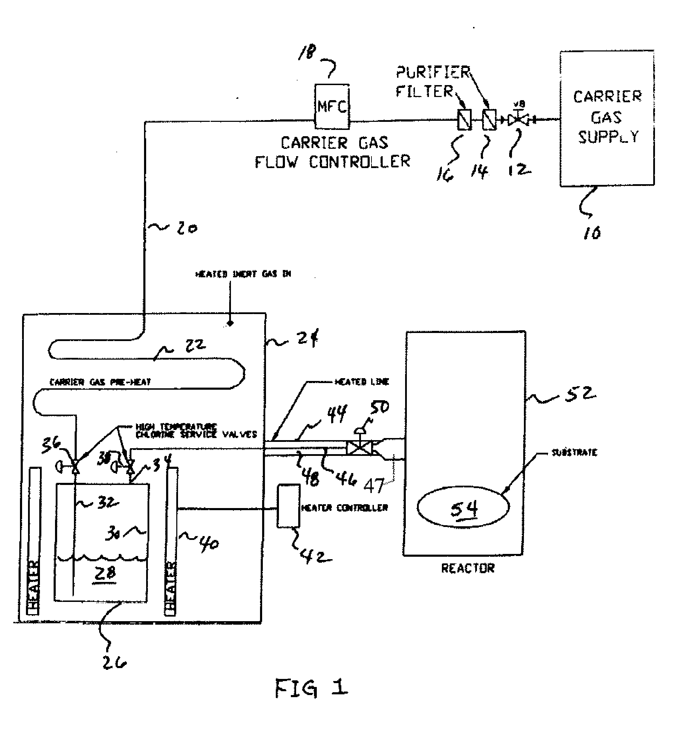

FIG 1 is a schematic illustration of an embodiment of the present invention for delivering GaCl₃ at high purity and at high flow rates for gallium-containing compounds synthesis.
FIG 2 is a graph of the corrosion byproduct totals for various metal alloys exposed to gallium trichloride and rinsed with water thereafter.

### DETAILED DESCRIPTION OF THE INVENTION

The apparatus and process of the present invention enables a chemical vapor deposition (CVD) gallium film deposition in an epitaxial reactor using high vapor pressure epitaxy (HVPE) by delivering to the reactor a high flow and high purity GaCl₃ vapor.

Conventional vapor delivery systems for solid precursors are not offered for high flow and high purity delivery of GaCl₃, because of the low vapor pressure of GaCl₃ in its solid state.

Existing liquid vapor delivery systems that can deliver such high flow rates can not accommodate melted (above 80°C) GaCl₃, because of their low temperature capabilities, and the highly corrosive nature of the chlorine chemistry, which is accelerated at higher temperatures.

The present invention was demonstrated as follows. GaCl₃ solid precursor was placed in a 316LSS (grade 316L Stainless Steel) bubbler container, where it is heated above its 78°C melting point. At this temperature, and above, it is a liquid and can be bubbled at low flow rates.

Additional heating of the GaCl₃ from it's melting point (78°C) up to 130°C raises the vapor pressure of the liquid GaCl₃ (the vapor pressure of GaCl₃ at 130°C is 90 Torr (12 kPa)) adequately to deliver high flow rates (300 to 400 g/hour) by bubbling. At these higher temperatures, carrier gas flow rates in the range of 5-15 liter/min will result in the desirable high mass flow rates, yet low enough to avoid turbulence of the liquid that can cause liquid to spit out of the container outlet in the form of a large droplet aerosol. Only saturated vapor is acceptable, when bubbling, to maintain a consistent mass transfer and avoid the particle problems that are often contributed by aerosol droplets.

The invention process utilizes purified carrier gas (H₂, Ar, He, or N₂) to bubble the GaCl₃. The ultra high purity (UHP) purifier removes moisture to below 10, preferably 5, parts per billion (ppb), preventing the generation of HCl by moisture reacting with the chlorine (in GaCl₃).

This removal of moisture from the carrier gas controls the HCl attack of the metal bubbler wetted surface, which can contribute metal impurities to the GaCl₃ precursor and cause corrosion failures. Metals contaminants can interfere with the epitaxial crystal growth of the gallium-containing films.

The increased corrosion rates of HCl at high temperatures has led to the addition of another optional feature to the invention. A fluoropolymer, either fluorinated ethylene-propylene ("FEP"), polytetrafluoroethylene ("PTFE") or PFA (copolymers or derivatives of polytetrafluoroethylene, hereinafter collectively polytetrafluoroethylene) protective coating can be molded onto the inside wetted surface of the metal or alloy, i.e. stainless steel (SS), bubbler to better prevent metal impurities contributed from the SS wetted surface. This coating also inhibits corrosion to the metal or alloy container if moisture is accidentally introduced.

Container, valves, tubing, and fittings preferably are 316L stainless steel ("SS") electropolished. The 316L SS valves preferably utilize a special PFA seat to sustain the high temperature of operation and resist chlorine attack. These components can also be Hastelloy, such as Hastelloy B-2 alloy Hastelloy B-3 alloy, such as Hastelloy C-22 alloy, Nickel or Monel. Hastelloy B-3 alloy has a composition by weight percent of: Ni - 65%, Mo - 28.5%, Cr - 1.5%, Fe - 1.5%, Co - 3%, W - 3%, Mn - 3%, Al - 0.5%, Ti - 0.2%, Si - 0.1 % and C - 0.01 %. Hastelloy C-22 alloy has a composition by weight percent of: Ni - 56%, Mo - 13%, Cr - 22%, Fe - 3%, Co - 2.5%, W - 3%, Mn - 0.5%, V - 0.35%, Si - 0.08% and C - 0.01 %. Alternatively, metals coated with silicon oxide ("silica") can be used to diminish corrosion. The silica can be amorphous silica, such as Siltek available from Restek of Bellefonte, PA, USA. The amorphous silica coating is preferably applied to 316L electropolished stainless steel or Hastelloy B-2 or Hastelloy B-3 or Hastelloy C-22. Another silicon corrosion resistance coating is fused silica, again applied to a metal, such as 316L SS. Table 1 shows the composition of relevant corrosion resistant alloys.

**Table 1**

| **Elements** | **Elgiloy** | **316LSS** | **Nickel 200** | **Hastelloy C-22** | **Hastelloy B-2** | **Hastelloy B-3** |
|---|---|---|---|---|---|---|
| | % | % | % | % | % | % |
| **Cr** | 19-21 | 16-18 | | 22 | 1 max | 1.5 |
| **Co** | 39-41 | - | | 2.5 max | 1 max | 3 max |
| **Cu** | - | - | 0.25 max | 0.5 max | 0.5 max | 0.2 max |
| **Fe** | 16 | bal(~66%) | 0.40 max | 3 | 2 max | 1.5 |
| **Mn** | 1.5-2.5 | 2.0 max | 0.35 max | 0.5 max | 1 max | 3 max |
| **Mo** | 6-8 | 2.0-3.0 | | 13 | 28 | 28.5 |
| **Ni** | 14-16 | 10.0-14.0 | 99.0 min | 56 | 69 | 65 |
| **Si** | - | 0.75 max | 0.35 max | 0.08 max | 0.1 max | 0.1 max |
| **V** | - | - | | 0.35 max | | |
| **W** | - | - | | 3 | | 3 max |
| **Carbon** | 0.15 max | 0.03 max | 0.15 max | 0.01 max | 0.01 max | 0.01 max |
| **Be** | 0.1 max | | | | | |
| **Nb** | | | | | | |
| **Ti** | | | | | | 0.2 max |
| **Al** | | | | | | 0.5 max |
| **S** | | | 0.01 max | | | |
| **P** | | | | | | |

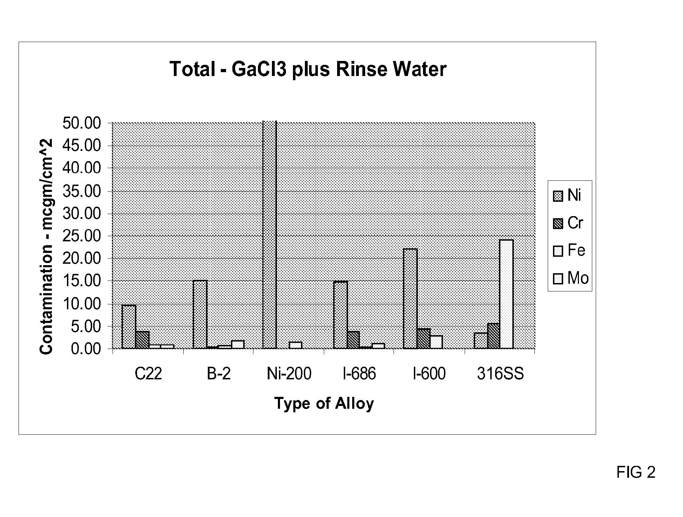

Tests on various alloys for materials of construction for containers, inlets, outlets, valves and delivery lines were conducted by exposure of the alloys to gallium trichloride. The results are tabulated in Table 2 below and show that Hastelloy C-22 exhibited the lowest measurable corrosion. Data was collected by comparing alloy coupon (sample) weight before and after contact with gallium trichloride and by analysis of both gallium trichloride exposed to the coupon and rinse water contacted with the coupon after gallium trichloride exposure. However, Hastelloy B-2 and B-3 alloys yielded the least volatile corrosion byproducts and therefore, is expected to produce gallium films with less metallic impurities. A comparison of total byproducts, shown in FIG 2, combines the corrosion byproducts found in the gaseous gallium trichloride after contact with certain of the alloy coupons and the corrosion byproducts found in the rinse water contacted with certain of the alloy coupons after the coupons were exposed to gallium trichloride.

**Table 2**

| Comparative Alloy Corrosion Rates by Weight and Metals Analysis | | | |
|---|---|---|---|
| | Estimate based on: | Coupon wt change | Metals extracted** |
| Rank | Description | avg mil/yr | avg mil/yr |
| 1 | C-22 | 0.028 | .026** |
| 2 | B-2 | 0.044 | 0.028* |
| 3 | Inc-686 | 0.054 | 0.033* |
| 4 | Inc-600 | 0.074 | 0.050* |
| 5 | 316SS | 0.065 | .060** |
| 6 | Nickel | 0.106 | .086** |
| 7 | Elgiloy | 0.217 | .183** |

**Table 3**

| Relative Metal Chloride Volatilities | | |
|---|---|---|
| **Metal** | **Metal Chloride** | **BP** - **°C** |
| **Chromium** | CrCl2 | 947(s) |
| | CrCl3 | 1300 |
| | CrO2Cl2 | 117 |
| **Cobalt** | CoCl2 | 1087 |
| **Copper** | CuCl | 1212 |
| | CuCl2 | d>300 |
| **Iron** | FeCl2 | 1024 |
| | FeCl3 | 315 |
| **Molybdenum** | MoCl2 | d 530 |
| | MoCl3 | (mp 1037) |
| | MoCl4 | 407 |
| | MoCl5 | 264 |
| | MoCl6 | 254(s) |
| **Nickel** | NiCl2 | 970(s) |
| **Tungsten** | WCl2 | d 589 |
| | WCl4 | d 498 |
| | WCl5 | 288 |
| | WCl6 | 341 |
| | WCl40 | 220 |
| | WCl2O2 | 260(s) |
| **Zinc** | ZnCl2 | 732 |

The bubbler is available with an optional molded PFA liner for applications that might need more protection from metal contaminants. In this case, all valves would be switched from 316L SS, to all perfluoropolymer, such as Teflon PFA (body and seats) valves.

The present invention will further be described with regard to the drawing. A high purity inert carrier gas comprising argon, helium, hydrogen, nitrogen or mixtures thereof is provided at an elevated pressure above atmospheric pressure in carrier gas supply 10. The carrier gas is dispensed at a flow rate of 5 to 15 liters per minute through valve 12, purifier 14 which removes any moisture to below 10, preferably 5, parts per billion and filter 16, which removes particulates, especially particulates that might be inadvertently generated in the purifier 14. The carrier gas if sufficiently pure can bypass any purifier or filter, optionally, carrier gas flow is measured and metered through mass flow controller 18.

The carrier gas is delivered through line 20 to an insulated shell 24 containing the gallium trichloride container 26. The carrier gas line is configured through one or more sinusoidal bends 22 to form a heat exchange surface that can be separately heated or as illustrated in the drawing, takes heat from the heater 40 for the container 26.

The heated carrier gas is delivered through valve 36 and enters the container 26 through diptube 32 as the valved inlet of the container 26. The outlet of the diptube is below the surface of the melted gallium trichloride 28, which is maintained in a liquid phase by heating the otherwise room temperature solid above its 78°C melting point by heater 40, which may encircle the container 26.

The container 26 is also called a "bubbler" because, carrier gas dispensed form diptube outlet 32 "bubbles" up through the melted liquid gallium trichloride to entrain gallium trichloride in the vapor phase for removal through valved outlet 34, controlled by valve 38. The heater 40 is controlled by a traditional heater controller 42.

The carrier gas saturated with gallium trichloride is removed from the container 26 in delivery line 44 which is a coaxial line having an inner line 46 carrying the gallium trichloride and an outer line 47 forming with the inner line 46 an annular space 48 which permits heated atmosphere (preferably inert nitrogen) to occupy the annular space and maintain the elevated temperature of the carrier gas and gallium trichloride being dispensed from the container 26 to the gallium-containing compound reactor 52 through valve 50 to form gallium-containing compound product on target 54.

This apparatus and method allow gallium trichloride to be delivered to the gallium-containing compound reaction zone in the reactor 52 at a flow rate of 300 to 400 grams per hour at 110°C to 140°C, which is desirable for economic production of high purity gallium-containing compounds.

The present invention has been described with reference to several exemplary embodiments, but the full scope of the invention should be ascertained from the claims which follow.

## Claims

1. An apparatus for delivering high purity gallium trichloride in the vapor phase to a reactor for producing gallium-containing products, comprising;
a source (10) of an inert carrier gas at a pressure above atmospheric pressure;
a heater (40) capable of heating the carrier gas to a temperature of at least 80°C;
a container (26) having a corrosive resistant inner surface having a supply of gallium trichloride (28), a valve controlled inlet for the carrier gas that forms a dip tube (32) with an outlet below the level of the gallium trichloride, a valve controlled outlet (34) for removing the carrier gas and gallium trichloride entrained in the carrier gas;
a heater (40) capable of heating the container sufficient to melt the gallium trichloride; and
a delivery line (44) connected to the valve controlled outlet for carrying the carrier gas and entrained gallium trichloride to a reaction zone (52) for converting the gallium trichloride to gallium-containing products.

2. The apparatus of Claim 1 including a purifier (14) upstream of the container capable of removing moisture from the carrier gas down to no more than 10 parts per billion.

3. The apparatus of Claim 2 wherein the source of carrier gas has a filter (16) downstream of the purifier.

4. The apparatus of any preceding claim wherein the heater capable of heating the carrier gas and the heater capable of heating the container are one heater.

5. The apparatus of any preceding claim wherein the source of carrier gas includes a mass flow controller (18).

6. The apparatus of any preceding claim wherein the container is in an insulated outer shell (24).

7. The apparatus of any preceding claim wherein the source of carrier gas includes a carrier gas line that is configured with sinusoidal bends (22) to provide sufficient heat exchange surface to heat the carrier gas proximate the heater capable of heating the carrier gas.

8. The apparatus of any preceding claim wherein the delivery line is a coaxial line with an inner line (46) conveying the carrier gas and entrained gallium trichloride and an outer coaxial line (47) providing an annular space (48) containing a heating medium.

9. The apparatus of any preceding claim wherein the container is constructed of a metal selected from: stainless steel, Hastelloy, Hastelloy B-2, Hastelloy B-3, Hastelloy C-22, Nickel, Monel, Inconel 686 and mixtures thereof.

10. The apparatus of any preceding claim wherein the delivery line is constructed of a metal selected from: stainless steel, Hastelloy, Hastelloy B-2, Hastelloy B-3, Hastelloy C-22, Nickel, Monel, Inconel 686 and mixtures thereof.

11. The apparatus of any preceding claim wherein the valved inlet, the valved outlet and the valves (36, 38) in such inlet and outlet are constructed of a metal selected from: stainless steel, Hastelloy, Hastelloy B-2, Hastelloy B-3, Hastelloy C-22, Nickel, Monel, Inconel 686 and mixtures thereof.

12. The apparatus of any preceding claim wherein the valves of the valved inlet and valved outlet have fluoropolymer seats.

13. The apparatus of any preceding claim wherein the container has an inner liner of fluoropolymer.

14. The apparatus of any one of Claims 1 to 12 wherein the container and the delivery line have inner surfaces that contact the gallium trichloride and those surfaces have a passivating layer of metal chloride.

15. The apparatus of any one of Claims 1 to 11 wherein the valved inlet, valved outlet and the valves in such inlet and outlet have inner surfaces that contact the gallium trichloride and those surfaces have a passivating layer of metal chloride.

16. The apparatus of any one of Claims 1 to 12 wherein the container and the delivery line have inner surfaces that contact the gallium trichloride and those surfaces have a passivating layer of a silicon-containing compound.

17. The apparatus of any one of Claims 1 to 11 wherein the valved inlet, valved outlet and the valves in such inlet and outlet have inner surfaces that contact the gallium trichloride and those surfaces have a passivating layer of silicon-containing compound.

18. A process for delivering vapor phase gallium trichloride to a reaction zone for synthesizing gallium-containing products, comprising;
heating a carrier gas, selected from hydrogen, nitrogen, helium, argon and mixtures thereof at a pressure above atmospheric pressure, to a temperature of at least 80°C;
injecting the carrier gas into a bath of melted gallium trichloride in a container to entrain the gallium trichloride in the carrier gas; and
removing the carrier gas and entrained gallium trichloride from the container and delivering the carrier gas and entrained gallium trichloride through a delivery line at a temperature of at least 80°C to a reaction zone for synthesizing gallium-containing products.

19. The process of Claim 18 including the step of purifying the carrier gas, by passing the carrier gas through a purifying media selective for the removal of moisture to reduce the moisture to no more than 10 parts per billion, prior to the carrier gas being injected into the container.

20. The process of Claim 18 or 19 wherein the carrier gas is flowed at a rate of 5 to 15 liters per minute.

21. The process of any one of Claims 18 to 20 wherein the gallium trichloride is delivered to the reaction zone at a rate of 300 to 400 grams per hour.

22. The process of any one of Claims 18 to 21wherein the gallium trichloride in the container is heated to a temperature in the range of 110°C to 140°C.

23. The process of any one of Claims 18 to 22 wherein the container and the delivery line have inner surfaces that contact the gallium trichloride and those surfaces are passivated by flowing a chlorinated gas through the container and the delivery line prior to delivering the entrained gallium trichloride.

24. The process of any one of Claims 18 to 23 conducted in an apparatus as defined in any one of Claims 1 to 17.
